# EUROPEAN PATENT SPECIFICATION

(11) **EP 3 943 958 B1**
(45) Date of publication and mention of the grant of the patent: **16.10.2024**
(21) Application number: 20186747.0
(22) Date of filing: 20.07.2020
(51) Int. Cl.: G01R 31/12

(54) **METHODS FOR DETERMINING THE PRESENCE OF AN ELECTRICAL DISCHARGE IN AT LEAST ONE PREDETERMINED AREA OF AN ELECTRICAL APPARATUS AND SYSTEM THEREFOR**
VERFAHREN ZUR BESTIMMUNG DES VORHANDENSEINS EINER ELEKTRISCHEN ENTLADUNG IN MINDESTENS EINEM VORBESTIMMTEN BEREICH EINER ELEKTRISCHEN VORRICHTUNG UND SYSTEM DAFÜR
PROCÉDÉS POUR DÉTERMINER LA PRÉSENCE D'UNE DÉCHARGE ÉLECTRIQUE DANS AU MOINS UNE ZONE PRÉDÉTERMINÉE D'UN APPAREIL ÉLECTRIQUE ET SYSTÈME ASSOCIÉ

(43) Date of publication of application: 26.01.2022
(73) Proprietor: ABB Schweiz AG, 5400 Baden (CH)
(72) Inventor: HENCKEN, Kai, 79539 Lörrach (DE); MARET, Yannick, 5405 Dättwil (CH)
(74) Representative: Zimmermann & Partner Patentanwälte mbB

(56) References cited:
- US-A- 5 256 976
- US-A1- 2012 265 458
- US-A1- 2015 268 292
- US-A1- 2016 139 196
- US-A1- 2018 106 880
- US-A1- 2018 252 759
- HEKMATI ARSALAN ED - DAVIES WILLIAM J: "Proposed method of partial discharge allocation with acoustic emission sensors within power transformers", APPLIED ACOUSTICS, ELSEVIER PUBLISHING, GB, vol. 100, 27 July 2015 (2015-07-27), pages 26 - 33, XP029276520, ISSN: 0003-682X, DOI: 10.1016/J.APACOUST.2015.07.011

## Description

### TECHNICAL FIELD

Embodiments of the present disclosure relate to a method for detecting an electrical discharge in an electrical apparatus, particularly partial discharges, and particularly in electrical switchgear. In particular, embodiments of the present disclosure relate to determining the presence of an electrical discharge in at least one predetermined area of an electrical apparatus. Further embodiments of the present disclosure relate to a detection system for detecting an electrical discharge in an electrical apparatus, particularly a detection system for carrying out said methods.

### BACKGROUND

Electrical apparatus, particularly medium-voltage or high-voltage electrical switchgear, may be susceptible to electrical discharges occurring in various components of the apparatus. A focus for monitoring of electrical apparatus is determining the spatial location of electrical discharges, in particular partial discharges. The presence of electrical discharges may be indicative of a defect in a component, which may lead to failure of the electrical apparatus. Identifying the point of origin of a partial discharge is important, as knowing the origin of the electrical discharge allows for repair or replacement of the defective component to be carried out. Further, identifying the point of origin, particularly which component in the electrical apparatus is affected, may provide further information about the criticality of the electrical discharge. A system for automatic identification and localization of electrical discharges in an electrical apparatus is desirable for reducing downtime caused by the shutdown of the electrical apparatus so that a service technician may diagnose the failure manually.

Several approaches for detecting partial discharges already exist in the state of the art. For example, detection systems may be used which are based on the effect of the discharge on the electrical quantities of the system, for example, the voltage and current measured through capacitive or inductive principles, or detection systems that detect electromagnetic or acoustic emissions from them. In order to localize the source of the partial discharge, existing systems may rely on a number of techniques. For example, a combination of multiple sensors, the signals from which are processed using a variety of techniques such as triangulation, may be used to identify the location of the partial discharge. Amplitude-based measurements may determine the attenuation of the signal as a function of distance between the source and the receiver. Direction-sensitive measurements may determine a direction of arrival of a wave at the receiver and combine several of these measurements to determine the location of the source. Existing systems, which rely on the processing of signals from many sensors and computations such as triangulation, have high computational demands and high overall cost of implementing, calibrating and maintaining. Further, high-speed acquisition of these signals may be required - for example, an electromagnetic signal sampled at 1 ns would only be able to resolve a location within 30 cm.

Prior art document US 2012/265458 teaches an arrangement for detecting and locating PD events in a motor stator, using high directivity antennas that may rotate or orbit around the stator axis, or the stator may be rotate. The detectors may also move up and down in the axis direction, or the stator may be moved. The detectors acquire PD signals from the stators while the detectors and/or the stator are rotated/moved, that are passed to a controller that detects/locates PD events based on the signals and the position/orientation of the stator/detectors. Further prior art is known from US2018/252759, US2015/268292, US5256976, and US2016/139196.

Further challenges arise when the possibility of an external disturbance or false positive is measured by the detection system. It is challenging to provide a detection system with accurate and reliable detection of actual electrical discharges, while also being resistant to external disturbances.

In addition, existing systems which rely on calculating respective time-of-flight of signals from multiple sensors may be problematic if the signals from each sensor are not properly synchronized. The synchronization of signals from these many sensors, as well as the high demands of computation of signals from these many sensors, may be challenging to overcome.

### SUMMARY

In view of the above challenges and problems arising in the state of the art, improved methods and systems for detecting partial discharges in electrical apparatus are sought.

According to a first aspect of the present disclosure, a method for determining the presence of an electrical discharge in at least one predetermined spatial area in an electrical apparatus is provided. The method includes providing a first directional sensing device directed to a first subset of the at least one predetermined spatial areas and at least one second directional sensing device directed to at least one second subset of the at least one predetermined spatial areas, providing a predetermined mapping comprising data corresponding to a position of the first and at least one second directional sensing devices, a direction in which each of the first and at least one second directional sensing devices are directed, and a position of the at least one predetermined spatial area, sensing at least two signals using the first and at least one second directional sensing devices, and processing the at least two signals based on the predetermined mapping to determine the presence of the electrical discharge in the at least one predetermined spatial area.

According to a second aspect of the present disclosure, a detection system for detecting an electrical discharge in an electrical apparatus is provided. The system includes a first directional sensing device and at least one second directional sensing device configured for sensing an electrical discharge, and a signal processing device configured for performing the method according to the first aspect.

According to a third aspect of the present disclosure, a method for determining the presence of an electrical discharge in at least one predetermined spatial area in an electrical apparatus is provided. The method includes providing a first directional sensing device configured to have an adaptive directional sensitivity, providing a predetermined mapping comprising data corresponding to a position of the first directional sensing device and a position of the at least one predetermined spatial area, directing the first directional sensing device to be sensitive to a first subset of the at least one predetermined spatial areas, sensing a first signal, directing the first directional sensing device to be sensitive to at least one second subset of the at least one predetermined spatial areas, sensing at least one second signal, and processing the first signal and the at least one second signal based on the predetermined mapping to determine the presence of the electrical discharge in the at least one predetermined spatial area.

According to a fourth aspect of the present disclosure, a detection system for detecting an electrical discharge in an electrical apparatus is provided. The system includes a first directional sensing device and a signal processing device configured for performing the method according to the third aspect.

Fifth and sixth aspects of the invention involve the use of the systems according to the second and fourth aspects.

Other embodiments include (non-volatile) computer-readable storage media or devices, and one or more computer programs recorded on one or more computer-readable storage media or computer storage devices. The one or more computer programs can be configured to perform particular operations or processes by virtue of including instructions that, when executed by one or more processors of a system, in particular a system as explained herein, cause the system to perform the operations or processes.

Aspects of the present disclosure provide systems and methods for locating the origin of an electrical discharge with lower computational demands, more reliable localization and improved resistance to external disturbances. The costs in implementing, operating and maintaining the detection system are also reduced.

Those skilled in the art will recognize additional features and advantages upon reading the following detailed description, and upon viewing the accompanying drawings.

### BRIEF DESCRIPTION OF THE DRAWINGS

The components in the figures are not necessarily to scale, instead emphasis being placed upon illustrating the principles of the invention. Moreover, in the figures, like reference numerals designate corresponding parts. In the drawings:
- Fig. 1: illustrates an internal side view of an electrical switchgear having a detection system according to embodiments of the present disclosure;
- Fig. 2: is a flow chart illustrating a method for determining the presence of an electrical discharge in at least one predetermined spatial area in an electrical apparatus according to embodiments of the present disclosure;
- Fig. 3: is a cross-sectional view of a compartment of an electrical apparatus having a detection system according to embodiments of the present disclosure;
- Fig. 4: is a flow chart illustrating a method for determining the presence of an electrical discharge in at least one predetermined spatial area in an electrical apparatus according to embodiments of the present disclosure;
- Fig. 5: is a signal diagram for an electrical discharge detected by a detection system according to embodiments of the present disclosure;
- Fig. 6: is a signal diagram for an external disturbance detected by a detection system according to embodiments of the present disclosure;
- Fig. 7: is a cross-sectional view of a compartment of an electrical apparatus having a detection system according to embodiments of the present disclosure;
- Fig. 8: is a flow chart illustrating a method for determining the presence of an electrical discharge in at least on predetermined spatial area in an electrical apparatus according to embodiments of the present disclosure;
- Fig. 9: is a signal diagram for an electrical discharge detected by a detection system according to embodiments of the present disclosure; and
- Fig. 10: is a signal diagram for an external disturbance detected by a detection system according to embodiments of the present disclosure.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment applies to a corresponding part or aspect in another embodiment as well.

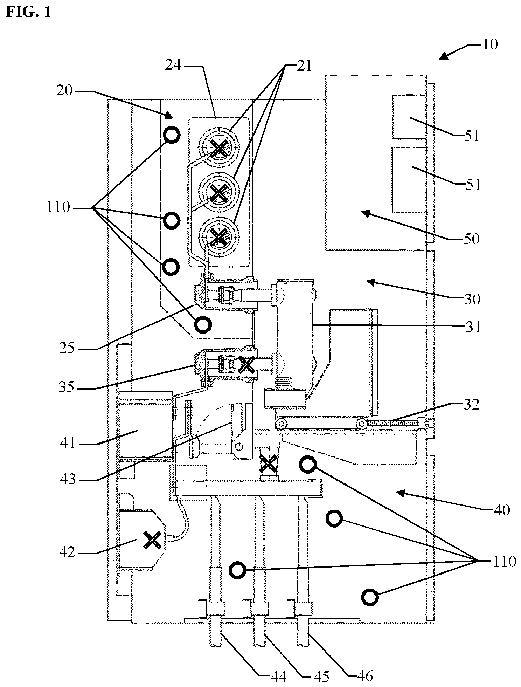

Reference will first be made to Fig. 1, which shows an internal side view of an electrical apparatus. In particular, the electrical apparatus exemplarily shown in Fig. 1 is a three-phase electrical switchgear 10, however the present disclosure is not limited thereto. Generally defined, the electrical apparatus may be any apparatus having a number of electrical components connected to each other.

The electrical apparatus may be divided into a plurality of compartments, and each respective compartment may be provided to house components of the electrical apparatus. However, the present disclosure is not limited thereto, and the electrical apparatus may be housed within a single housing with no compartments, or may be an open-air electrical apparatus. As exemplarily shown in the electrical switchgear 10 of Fig. 1, the plurality of compartments may include, for example, a busbar compartment 20, a circuit breaker compartment 30, a cable terminal compartment 40 and a control compartment 50.

Busbar compartment 20 is provided to house a plurality of busbars. In the exemplary three-phase electrical switchgear 10, three busbars 21 are provided. Busbars 21 serve as the connections of the electrical switchgear 10, and may extend horizontally and protrude out of busbar compartment 20 such that busbars 21 may be connected to the respective busbars of a neighbouring electrical switchgear. Busbars 21 may be supported by at least one insulating busbar support 24, and may include a plurality of insulators. Busbar support 24 may be constructed so as to support all three busbars 21 simultaneously. Each one of busbars 21 may be connected to each respective one of a plurality of bushings or contact fingers 25, wherein bushings or contact fingers 25 are provided to pass through a separating wall between busbar compartment 20 and circuit breaker compartment 30.

Circuit breaker compartment 30 is provided to house a plurality of circuit breakers 31. An input side of each one of circuit breakers 31 is connected to each respective one of bushings or contact fingers 25. An output side of each one of circuit breakers 31 are connected to each respective one of bushings or contact fingers 35 provided to pass through a separating wall between circuit breaker compartment 30 and cable terminal compartment 40. As exemplarily shown in the electrical switchgear of Fig. 1, bushings or contact fingers 25, 35 are configured to be pluggable components, such that circuit breakers 31 may be plugged and unplugged from bushings or contact fingers 25, 35 by moving circuit breakers 31 on drawers 32.

Cable terminal compartment 40 is provided to house a variety of components in the exemplary electrical switchgear 10. In particular, cable terminal compartment 40 houses current transformers 41, voltage transformers 42, earthing switches 43 and cable terminations 44, 45, 46. An input side of each one of voltage transformers 42 is connected to each respective one of bushings or contact fingers 35. Cable terminations 44, 45, 46 serve as the connections of the electrical switchgear, and are exemplarily provided to pass through a floor panel of the electrical switchgear 10.

Control compartment 50 is provided to house a variety of control components 51 in the exemplary electrical switchgear 10. The control components 51 may include, for example, at least one of a controller, a monitoring device, a data logging device or a display device. Providing such control components 51 in a separate compartment allows for the control components 51 to be electrically shielded from other compartments and other components in the electrical switchgear 10 which operate at significantly higher voltages than the control components 51, preventing electrical interference and erroneous operation of the control components 51.

The electrical apparatus, may be, for example, a medium- or high-voltage electrical apparatus. In the context of the present disclosure, the term "medium-voltage" may refer to a voltage of at least 1 kV Particularly, the term "medium-voltage" may refer to a voltage of at least 1 kV and up to 69 kV Further, the term "high-voltage" in the context of the present disclosure may refer to a voltage of at least 69 kV Particularly, the term "high-voltage" may refer to a voltage of at least 69 kV and up to 230 kV

Although the electrical apparatus exemplarily shown in Fig. 1 is an electrical switchgear, the present disclosure is not limited thereto. The electrical apparatus, particularly the medium- or high-voltage electrical apparatus, may be at least one of the group comprising an electrical air-insulated switchgear, an electrical gas-insulated switchgear, an air-insulated electrical transformer, a gas-insulated electrical transformer, an electrical motor, an electrical motor drive, or an entire electrical substation or any hall or room containing a number of the electrical equipment mentioned above. The electrical apparatus may be an electrical device configured for alternating current or direct current.

In the electrical apparatus, abnormal electrical discharges may be indicative of a defect in an electrical component. In particular, partial discharges may occur locally at or within a component, potentially causing damage to the component or failure of the electrical apparatus. A partial discharge may occur due to a localized dielectric breakdown of a small portion of an electrical insulation when subjected to high voltage stress. A "partial discharge" is so named as the discharge does not completely bridge the space between two conductors, or between one conductor and ground, but instead is limited to only a portion of the insulation or at a boundary between insulation materials, such that the discharge only partially bridges the space between two conductors or between a conductor and ground.

An electrical discharge event may dissipate energy in the form of electromagnetic waves, heat, sound and light. In other words, a single occurrence of an electrical discharge in an electrical apparatus emits energy, particularly pulses of energy, in the form of an electromagnetic wave and an acoustic wave, among others. The latter arises as parts of the discharge energy is converted into heat. Sensors may be deployed within the electrical apparatus to detect these various waves in order to monitor the occurrence of electrical discharge events.

In one type of electrical discharge, a partial discharge may occur within an insulation material of a component in an electrical apparatus. In this case, the partial discharge may originate at the location of a gas-filled void, crack or inclusion present in a solid insulation material, or may originate at the location of a gas-filled bubble within a liquid insulation material. In the context of the present disclosure, such a partial discharge is referred to from hereafter as an "internal partial discharge".

In another type of electrical discharge, a partial discharge may occur on the surface of an insulation material of a component in an electrical apparatus. In this case, the partial discharge may originate at the interface between a solid insulation material and the surrounding gas, particularly air. In the context of the present disclosure, such an electrical discharge is referred to from hereafter as a "surface partial discharge".

In yet another type of electrical discharge, a partial discharge may occur at the surface of a metallic component in an electrical apparatus, for example, a corona shield, an electrode or a metallic shield. In this case, the electric field at the surface of the metallic component causes the gas immediately surrounding the metallic surface to ionize, creating a region of plasma. In the context of the present disclosure, such an electrical discharge is referred to from hereafter as a "corona partial discharge". Further discharge types which occur in air and/or may interact with the air as an acoustic medium may also be similarly classified.

An electrical discharge event occurring at or within an insulation material, i.e. an internal partial discharge or a surface partial discharge, causes deterioration of the insulation material. With repetitive electrical discharge, the insulation material becomes progressively less effective at insulating the component, allowing further electrical discharge events to occur, eventually leading to complete electrical breakdown. Chemical transformation of the insulating material around the site of the electrical discharge tends to increase conductivity of the insulating material, further accelerating the breakdown process. Electrical discharges of the internal partial discharge type or the surface partial discharge type have the potential to cause critical damage to the component in the electrical apparatus in a short time, possibly causing complete failure of the electrical apparatus.

On the other hand, an electrical discharge event occurring at the surface of a metallic component, i.e. a corona partial discharge, may be tolerated by the electrical apparatus for some time before it becomes a critical problem. A corona partial discharge may cause acoustic or electromagnetic noise, may generate heat or active chemical species, like ozone, but may not result in damage to a component of the electrical apparatus.

It is desirable to identify the location of origin of the electrical discharge. Particularly, the location of the electrical discharge originating from a specific defective component in the electrical apparatus may be identified, such that the specific defective component may be serviced or replaced. In the context of the present disclosure, determining the location of the origin of an electrical discharge may include determining the presence or absence of an electrical discharge event in at least one particular predetermined spatial area of the electrical apparatus, particularly a partial discharge event, in order to determine whether the signals received originate from an electrical discharge event.

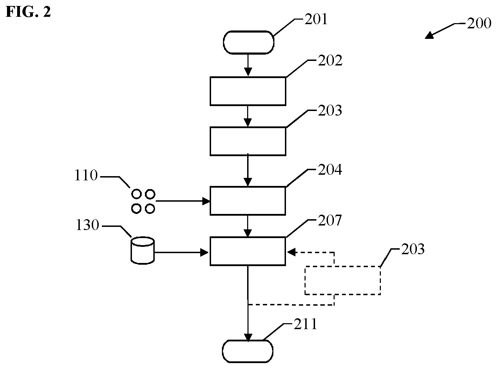

Reference will now be made to Fig 2, which shows a flowchart of a method 200 according to aspects of the present disclosure. The method starts at block 201. According to an aspect of the present disclosure, a method 200 for determining the presence of an electrical discharge in at least one predetermined spatial area in an electrical apparatus is provided. The method includes providing 202 at least one sensing device configured for sensing the electrical discharge, such that the at least one sensing device is sensitive to one or more of the at least one predetermined spatial area, providing 203 a predetermined mapping comprising data corresponding to a position, and optionally an orientation, of the at least one sensing device and a position of the at least one predetermined spatial area, sensing 204 at least one signal using the at least one sensing device, and processing 207 the at least one signal based on the predetermined mapping to determine the presence of the electrical discharge in the at least one predetermined spatial area. The method 200 concludes at block 211.

In the context of the present disclosure, the term "predetermined spatial area" may be an area being monitored by the detection system according to embodiments described herein. Particularly, a "predetermined spatial area" may be a predetermined location of interest, in which detecting the presence or absence of an electrical discharge is desired. A "predetermined spatial area" may be defined as a single point in space, an area on a surface in space, or a volume in space.

During development and continued operation of the electrical apparatus, knowledge of which electrical components are more susceptible to electrical discharges, particularly partial discharges, can be gathered. Further knowledge about the types of discharges which affect certain electrical components more than others can also be gathered. Such knowledge can be combined with the known locations and orientations of electrical components to generate a predetermined mapping of the spatial locations in the electrical apparatus in which electrical discharges may be likely to occur.

The predetermined mapping may contain sufficient information so as to represent a so-called "virtual" electrical apparatus. Possible configurations of a detection system in the "virtual" electrical apparatus may be calculated or modelled to determine the detection sensitivity to specific predetermined spatial areas, and said configuration may then be implemented in a detection system of a "real" electrical apparatus. Signals received by sensing devices of a detection system in the "real" electrical apparatus may then be compared to the "virtual" electrical apparatus, i.e. the predetermined mapping, to determine the presence or absence of an electrical discharge in predetermined spatial areas.

In some implementations, the predetermined mapping 130 may be provided as a complete mapping which includes data and/or information for all predetermined spatial areas being monitored. Alternatively, in other implementations, the method may include a predetermined mapping for each one of the predetermined spatial areas. In this case, the providing step 203 is performed for each one of the predetermined spatial areas which are to be monitored. In other words, in some implementations, a first predetermined mapping 130 corresponding to the data and/or information relevant to a first predetermined spatial area is provided in providing step 203, and the sensing 204 and processing 207 steps are performed for the first predetermined spatial area. Subsequently, the method may include a repeating portion, whereby at least one second predetermined mapping 130 corresponding to the data and/or information relevant to at least one second predetermined spatial area is provided in providing step 203, and the processing step 207 is performed for the at least one second predetermined spatial area. Further optionally, the sensing step 204 may also be repeated for the at least one second predetermined spatial area, such that the repeating portion includes the providing 203, the sensing 204 and the processing 207 steps. Such a repeating process is depicted by the optional dashed features shown in Fig. 2.

Referring once again to Fig. 1, an exemplary predetermined mapping is shown with crosses, in which it has been identified that busbars 21, bushings or contact fingers 35, transformers 42 and the terminals of earth switches 43 are likely sites for partial discharge. Such a mapping is only provided as an example - the mapping may include any number of electrical components provided at any location of electrical apparatus 10.

According to embodiments, which may be combined with other embodiments described herein, the predetermined mapping may further include additional information relating to the properties of the electrical components comprised in electrical apparatus 5. For example, the predetermined mapping may include information about the type of component, statistical likelihood of an electrical discharge to occur, statistical likelihood of particular types of electrical discharge to occur, locations of notable features of the electrical component e.g. corona shields or exposed metallic components, or maintenance information e.g. expected lifetime or date last replaced. The predetermined mapping may further include CAD data depicting a topology or a boundary volume of the electrical components comprised in electrical apparatus 5.

The predetermined mapping may further include additional information relating to known sources of interference, particularly an internal or external disturbance. For example, it may be known that a specific electrical component, e.g. an electric motor, emits an acoustic wave during normal operation. If the external disturbance is detected and its origin determined to correspond to a location known to be a source of interference, it may be assessed as an internal or external disturbance by the detection system, instead of being assessed as a possible electrical discharge.

In order to monitor the electrical apparatus 10, particularly the electrical components comprised in the electrical apparatus 10, a plurality of sensing devices 110 may be provided. Sensing devices 110 may be configured to detect an electrical discharge. Particularly, sensing devices 110 may be configured to detect at least one of an electromagnetic wave, including a light wave, or an acoustic wave emitted by the electrical discharge. As exemplarily shown in Fig. 1, the plurality of sensors 110 may be positioned within electrical apparatus 5 in the vicinity of likely sites of electrical discharge, and arranged in such a way as to allow for determining the presence or absence of an electrical discharge in predetermined spatial areas. The plurality of sensors 110 includes four sensors located in the busbar compartment 20 and four sensors located in the cable terminal compartment 40, however the present disclosure is not limited thereto - any number of sensors may be provided at any location and in any orientation.

As mentioned above, an electrical discharge event dissipates energy in the form of electromagnetic waves, heat, sound and light. The plurality of sensing devices 110 may include any sensing devices known in the art which are configured for sensing electromagnetic waves, infrared waves, acoustic waves or light waves. Particularly, the plurality of sensing devices 110 may be configured for sensing electromagnetic waves or acoustic waves. For example, the plurality of sensing devices 110 may include a microphone which is sensitive to acoustic waves, an antenna which is sensitive to electromagnetic waves, an infrared sensor which is sensitive to infrared waves, etc. Optionally, the plurality of sensing devices 110 may include a sensing device which is sensitive to more than one type of energy. For example, a microphone may be used not only for detecting an acoustic wave, but also for detecting an electromagnetic wave, e.g. a MEMS microphone.

The predetermined mapping may further include information relating to the sensing devices 110. Particularly, the predetermined mapping may include the spatial location of each one of sensing devices 110, as well as the relative spatial location between each one of sensing devices 110 and each one of the electrical components. More particularly, the predetermined mapping may include a distance between each one of sensing devices 110 and each one of the electrical components. Alternatively, said distance between each one of sensing devices 110 may be determined from the predetermined mapping based on the spatial locations of each one of sensing devices 110. By containing such information in the predetermined mapping, an expected time of flight of a possible signal from an electrical component to each respective sensing device 110 may be determined or even further included in the predetermined mapping itself. The expected time of flight may be determined or stored based on the type of sensing device, for example, an expected time of flight for an acoustic sensor and an expected time of flight for an electromagnetic sensor may be determined or stored.

The plurality of sensing devices 110 may be configured to be sensitive to a signal only in a specific direction. That is, the plurality of sensing devices 110 may include directional sensing devices. For example, a unidirectional microphone, e.g. a cardioid microphone, may be provided for directional sensing of acoustic waves. In the present disclosure, any directional sensing device known in the state of the art may be included.

The predetermined mapping may also include information related to the spatial sensitivity of each respective sensing device 110. Particularly, the predetermined mapping may include information related to the directionality of each respective sensing device 110. The directionality of each respective sensing device 110 may include information relating to which electrical components each respective sensing device 110 is sensitive.

Each respective sensing device 110 may have an adaptive directional sensitivity, such that the directional sensitivity of each respective sensing device 110 may be changed. A number of predetermined orientations may be provided, in which each respective sensing device 110 may be physically oriented, e.g. by a movable component of the sensing device such as an antenna or a parabolic dish.

Alternatively, the sensing device 110 may be of the beamforming type, in which the sensing device 110 includes a cluster of sensors which may be "selected" or "configured" so as to have selective directional sensitivity. For example, such beamforming type sensing devices may further include a controller for controlling which of the sensors of the cluster of sensors is active, such that the directional sensitivity is changed based on which subset of sensors is selected.

The present disclosure may also employ sensing devices 110 wherein each respective sensing device 110 may have a fixed directional sensitivity. For example, a first directional sensing device may be arranged so as to be sensitive to electrical discharges occurring in a first electrical component and a second electrical component, but not a third electrical component, while a second directional sensing device may be arranged so as to be sensitive to electrical discharges occurring in the second electrical component and the third electrical component, but not the first electrical component. Such information relating to the per-component sensitivity of each of sensing devices 110 may be included in the predetermined mapping. For example, the predetermined mapping may include a list of which electrical components are located in a sensitive zone of each respective sensing device 110.

In the context of the present disclosure, the term "processing the at least one signal" refers to any form of signal processing known in the state of the art. Particularly, the "processing" may include any one of scaling, filtering or delaying the at least one signal, comparing, correlating or combining the at least one signal to another signal or to the predetermined mapping, or combining the at least one signal with another signal e.g. through addition or multiplication. In cases where the at least one signal includes two or more signals, the processing may include comparing, correlating or combining one of the two or more signals with a further one of the two or more signals. The processing may be performed on a signal processing device, for example, an analog or digital signal processing device. The signal processing device may include one or more filters and/or one or more analog-to-digital converters (ADC) or digital-to-analog converters (DAC).

According to an embodiment, which may be combined with other embodiments described herein, the sensing and the processing may be performed sequentially for each one of the at least one predetermined spatial areas. Particularly, the sensing may be performed such that a first one of the at least one signal is sensed using a first one of the at least one sensing device, and the sensing of at least a second one of the at least one signal using at least a second one of the at least one sensing devices is performed thereafter. By sensing the respective signals or the at least one signal from each of the at least one sensing devices sequentially, the detection system may re-orient or adjust the directional sensitivity of the at least one sensing device between sensing subsequent ones of the at least one signal. This may allow for multiple predetermined spatial areas to be probed by a reduced number of sensing devices, or may allow for all predetermined spatial areas to be probed by a single sensing device.

Alternatively, the sensing, and optionally the processing, may be performed simultaneously for each one of the at least one predetermined spatial areas. Particularly, the sensing may be performed such that the at least one signal is sensed using each of the respective at least one sensing devices simultaneously, and the subsequent processing of each one of the at least one signal may be performed simultaneously after the sensing, or may be performed sequentially after the sensing. This simultaneous sensing allows for each one of the at least one signal to be time-synchronized, allowing for time-based techniques such as signal delaying to be used to determine the presence or absence of an electrical discharge in the at least one predetermined spatial areas to be performed.

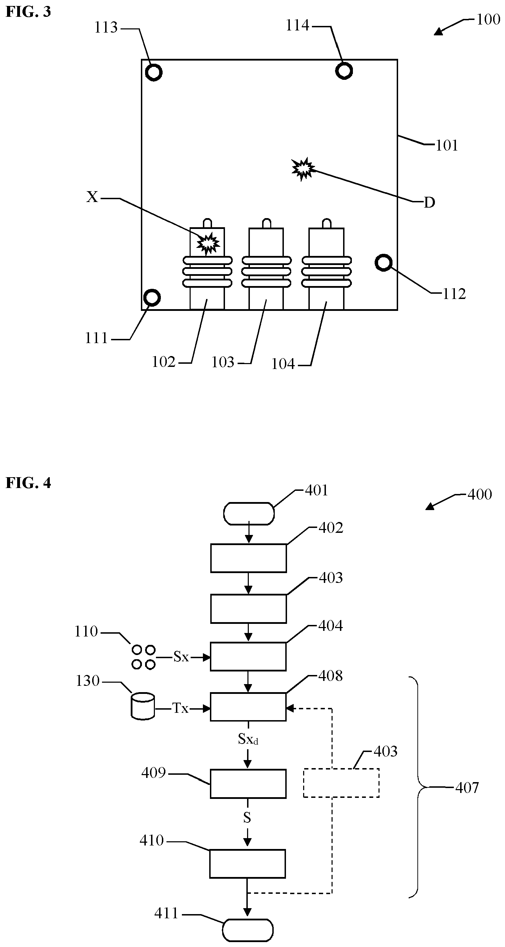

Reference will now be made to Fig. 3, which shows a simplified exemplary electrical apparatus and a detection system 100 according to a first aspect of the present disclosure. The electrical apparatus includes a compartment 101, inside which a first electrical component 102, a second electrical component 103 and a third electrical component 104 are provided. First, second and third electrical components 102, 103, 104 are exemplarily shown as being three electrical insulators or bushings, however the number and type of electrical components is not limited thereto. As exemplarily shown, an electrical discharge X may occur within first electrical component 102.

Detection system 100 includes at least one sensing device configured for sensing the electrical discharge X. As exemplarily shown, detection system 100 includes a first sensing device 111, a second sensing device 112, a third sensing device 113 and a fourth sensing device 114, however any number of sensing devices may be included. Each sensing device 111-114 may be, for example, omnidirectional sensing devices with no particular directional sensitivity.

Reference will now be made to Fig. 4, which illustrates a flowchart of a method 400 according to an embodiment of the present disclosure, which may be combined with other embodiments described herein. Method 400 starts at block 401 and ends at block 411. Method 400 is provided as an extension embodiment of the method 200 described above and in Fig. 2. In method 400, the processing 407 further includes delaying 408 the at least one signal S1-S4 with a respective time delay T1-T4 to generate at least one delayed signal S1_{d}-S4_{d}, wherein the time delay T1-T4 is based on the predetermined mapping 130, combining 409 the at least one delayed signal S1_{d}-S4_{d} to generate at least one combined signal S, and determining 410 the presence of the electrical discharge X in the at least one predetermined spatial area from the at least one combined signal S. Note that elements of the flowchart of Fig. 4 which include dashed lines are optional elements.

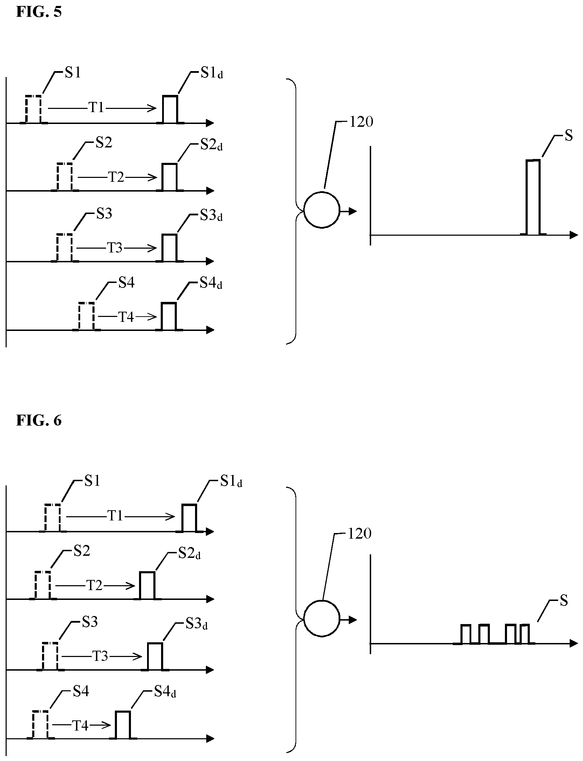

Further description of the method 200 in the following will make further reference to Fig. 5, which shows a signal diagram of the signals detected by detection system 100 using method 200.

In the sensing step 202, at least one signal S1-S4 is detected by at least one sensing device 110. Methods of the present disclosure are particularly powerful when multiple signals detected by multiple sensing devices are processed to determine the presence or absence of an electrical discharge. Method 400 may include providing 402 two or more sensing devices 111-114 configured for sensing the electrical discharge X, such that the two or more sensing devices 111-114 are sensitive to one or more of the at least one predetermined spatial areas. Particularly, method 400 may provide two or more sensing devices 111-114 sensitive to a first predetermined spatial area. Similarly, method 400 may further include sensing 404 two or more signals S1-S4 using the two or more sensing devices 111-114 and processing 407 the two or more signals S1-S4 based on the predetermined mapping 130 to determine the presence of the electrical discharge X in the at least one predetermined spatial area.

In the present example for the exemplary electrical apparatus shown in Fig. 3, first signal S1 is detected by first sensing device 111, second signal S2 is detected by second sensing device 112, third signal S3 is detected by third sensing device 113 and fourth signal S4 is detected by fourth sensing device 114. As an example, first electrical component 102 may be of interest to be monitored, so the location of first electrical component 102 may be provided as the predetermined spatial area. Due to the different distances between each one of first, second, third and fourth sensing devices 111-114 and first electrical component 102, i.e. the different distances between each one of first, second, third and fourth sensing devices 111-114 and the predetermined spatial area, the first, second, third and fourth signals S1-S4 are sensed by each respective sensing device with a respective delay based on the time of flight from the source to the respective sensing device, as exemplarily shown in the signal diagrams of Fig. 5.

The two or more signals S1-S4 may be time-synchronized to more reliably determine the presence or absence of an electrical discharge in the at least one predetermined area. According to an embodiment, which may be combined with other embodiments described herein, method 200 may include sensing 202 two or more signals S1-S4 using two or more sensing devices 111-114, wherein the two or more signals are time synchronized.

In the delaying step 203, based on the information contained in a predetermined mapping, a respective time delay T1-T4 may be applied to each of first, second, third and fourth signals S1-S4 in order to spatially normalize each of first, second, third and fourth signals S1-S4 with respect to the location of first electrical component 102. Each resulting delayed signal may be combined in order to determine whether the electrical discharge X is present in the predetermined spatial area, i.e. whether the electrical discharge X originated from first electrical component 102. In other words, a "virtual" sensing device is generated, wherein each of the first, second, third and fourth sensing devices 111-114 are combined so that the effective sensing position of the "virtual" sensing device is at the same position as first electrical component 102. The effective sensing position of this "virtual" sensing device may be repositioned by applying different time delays T1-T4 corresponding to other electrical components, e.g. second electrical component 103 or third electrical component 104.

According to an embodiment, which may be combined with other embodiments described herein, the predetermined mapping 130 may include data corresponding to relative spatial distances and/or expected times of flight between each of the at least one predetermined spatial areas and each of the at least one sensing device 111-114, and the time delay T1-T4 is based on the relative spatial distances and/or expected times of flight. In the present example, the predetermined mapping 130 may include the spatial distances and/or expected times of flight from first electrical component 102 to each one of first, second, third and fourth sensing devices 111-114, the spatial distances and/or expected times of flight from second electrical component 102 to each one of first, second, third and fourth sensing devices 111-114, and the spatial distances and/or expected times of flight from third electrical component 102 to each one of first, second, third and fourth sensing devices 111-114, wherein each one of first, second and third electrical component 102, 103, 104 corresponds to a first, second and third predetermined spatial area, respectively. Particularly, the respective spatial distances may be included in the predetermined mapping in the form of a predetermined time delay T1-T4.

For monitoring of the first electrical component 102, the respective time delays T1-T4 are based on the respective spatial distances between first, second, third and fourth sensing device 111-114 and the first electrical component 102. Each of first, second, third and fourth signals S1-S4 are delayed by each respective time delay T1-T4 to generate a respective first, second, third and fourth delayed signal S1_{d}-S4_{d}.

In the combining step 204, each one of first, second, third and fourth delayed signals S1_{d}-S4_{d} are combined to generate combined signal S. The combining may be performed by a signal processing device 120, which accepts each one of first, second, third and fourth delayed signals S1_{d}-S4_{d} as inputs and generates combined signal S as an output. The combination of first, second, third and fourth delayed signal S1_{d}-S4_{d} may be a sum or a product.

Combining first, second, third and fourth delayed signals S1_{d}-S4_{d} into a single combined signal S may allow for a less expensive detection system 100. For example, first, second, third and fourth signals S1-S4 may be delayed in the delaying step 203 using analog delays, and the resulting analog signals of the first, second, third and fourth delayed signals S1_{d}-S4_{d} may be combined into a single analog combined signal S prior to being digitized by an analog-digital converter (ADC), thus reducing the number of ADCs required to process each of the four signals in signal processing device 120.

Finally, in the determining step 206, it can be determined from combined signal S whether the electrical discharge X originated from first electrical component 102. In the present example, each one of first, second, third and fourth delayed signals S1_{d}-S4_{d} are synchronized, so the resulting combined signal S may have a particular signature, e.g. a short, sharp signal as exemplarily shown, which verifies that electrical discharge X was present in the predetermined spatial area corresponding to first electrical component 102, strongly indicating that the electrical discharge originated from first electrical component 102.

According to an embodiment, which may be combined with other embodiments described herein, the predetermined mapping 130 may include data corresponding to at least one reference signal, and the processing 407 further includes comparing or correlating the at least one combined signal S to the at least one reference signal. The predetermined mapping may include one or more reference signals corresponding to a verified signal. The signature of combined signal S may be compared or correlated to one or more reference signals included in the predetermined mapping to determine whether the combined signal S represents a confirmation of the presence or absence of electrical discharge X in the predetermined spatial area, e.g. whether or not the electrical discharge X originated from first electrical component 102.

Method 400 described in the present disclosure may be implemented to monitor a single electrical component. However, in typical embodiments, detection system 100 either repeats or performs in parallel the method 400 for each electrical component being monitored. According to an embodiment, which may be combined with other embodiments described herein, the method 400 is provided for determining the presence of an electrical discharge X in at least two predetermined spatial areas in the electrical apparatus. The method 400 further includes performing the delaying 408, the combining 409 and the determining 410 steps wherein the respective time delay T1-T4 is based on the distance between the respective sensing device 111-114 and a first one of the two or more predetermined spatial areas, and performing the delaying 408, combining 409 and determining 410 steps wherein the respective time delay T1-T4 is based on the distance between the respective sensing device 111-114 and a further one of the two or more predetermined spatial areas.

Optionally, the method 400 may include an additional providing step 403 whereby a second predetermined mapping 130 including data and/or information relevant to the further one of the two or more predetermined spatial areas is provided.

The performing of the delaying 408, combining 409 and determining 410 steps may be sequential, i.e. a serial process, simultaneous, i.e. a parallel process, or a combination of both. For example, the delaying 408, combining 409 and determining steps 410 may all be performed simultaneously for all predetermined spatial areas. Alternatively, the delaying 408 and combining 409 steps may be performed sequentially for each one of the two or more predetermined spatial areas, and the determining 410 step may be performed simultaneously for all predetermined spatial areas.

In the present example, detection system 100 would apply respective time delays T1-T4 for first electrical component 102, combine the resulting delayed signals S1_{d}-S4_{d}, and assess combined signal S. Next, or simultaneously, detection system 100 would apply respective time delays T1-T4 for second electrical component 103 combine the resulting delayed signals S1_{d}-S4_{d}, and assess combined signal S. Finally, or simultaneously, detection system 100 would apply respective time delays T1-T4 for second electrical component 103 combine the resulting delayed signals S1_{d}-S4_{d}, and assess combined signal S. The sequential assessment of each combined signal S for each one of first, second and third electrical component 102-104, or the simultaneous assessment of all combined signals S for each one of first, second and third electrical component 102-104, would therefore allow for determining the presence or absence of the electrical discharge X in each of the first, second and third predetermined spatial areas, and in turn allows for determining in which one of the electrical components the electrical discharge X originated.

Accordingly, detection system 100 is also resistant to signals from internal or external disturbances. For example, a disturbance D may occur as shown in Fig. 3 such that first, second, third and fourth sensing devices 111-114 may detect the disturbance D, potentially leading to an erroneous result. However, due to the application of the respective time delays and combining the resulting delayed signals, detection system 100 is resistant to an erroneous result being detected due to disturbance D.

The sensing of disturbance D by detection system 100 is exemplarily shown in Fig. 5. The origin of disturbance D is approximately equidistant from each one of first, second, third and fourth sensing devices 111-114, and in the present example the respective first, second, third and fourth signals S1-S4 are time-synchronized, so the resulting first, second, third and fourth signals S1-S4 are detected by first, second third and fourth sensing devices 111-114 at similar times. However, when monitoring first electrical component 102 similarly to Fig 4, the respective time delays T1-T4 are applied to generate first, second, third and fourth delayed signals S1_{d}-S4_{d} which are subsequently combined to generate combined signal S. Since first, second, third and fourth delayed signals S1_{d}-S4_{d} are not synchronized, the resulting combined signal S exhibits a particular signature. For example, the resulting combined signal S may have a number of non-synchronized, low-intensity pulses as shown in Fig. 6, as the combination of the delayed signals S1_{d}-S4_{d} does not lead to an addition or multiplication of the intensity. As a further example, if the external disturbance D emits a longer duration pulse, the delayed signals may slightly overlap, generating a combined signal S having a longer, flat signal of similar low-intensity. This is in stark contrast to the sharp, high-intensity signal exhibited in Fig. 5, where the delayed signals S1_{d}-S4_{d} are synchronized, generating an addition or multiplication of the intensity. Based on the signature of the combined signal S, e.g. by implementing an intensity threshold criteria, it can be determined that disturbance D did not originate from first electrical component 102.

As described above, method 400 may be further repeated for the second and third predetermined spatial areas, i.e. for second electrical component 103 and third electrical component 104. Since the location of the origin of disturbance D does not correspond to any of the predetermined spatial areas, i.e. any of the locations of first, second and third electrical components 102-104, none of the combined signals S would have signatures which indicate the presence of disturbance D within each respective predetermined spatial area, i.e. that disturbance D does not originate from any of first, second or third electrical components 102-104.

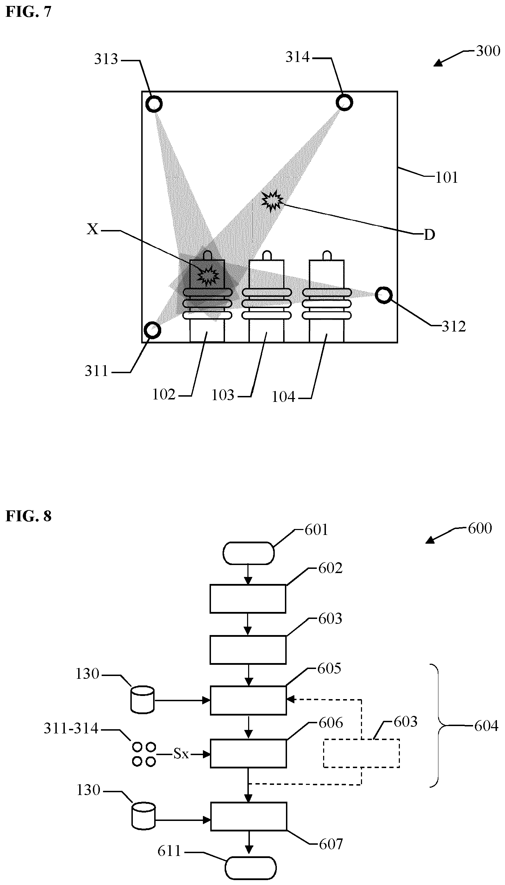

Reference will now be made to Fig. 7, which shows a simplified exemplary electrical apparatus and a detection system 300 according to embodiments of the present disclosure. Similarly to the electrical apparatus of Fig. 3, the electrical apparatus includes a compartment 101, inside which a first electrical component 102, a second electrical component 103 and a third electrical component 104 are provided.

Detection system 300 includes at least one directional sensing device configured for sensing the electrical discharge X. As exemplarily shown, detection system 300 includes a first directional sensing device 311, a second directional sensing device 312, a third directional sensing device 313 and a fourth directional sensing device 314, however any number of directional sensing devices may be included. Each directional sensing device 311-314 may be directed to a subset of at least one predetermined spatial area. In the present example, the first, second and third predetermined spatial areas may be provided, which correspond to the spatial areas or positions of the first, second and third electrical component 102-104. In other words, each directional sensing device 311-314 is directed to be sensitive to electrical discharges originating from one or more of the first, second and third electrical component 102-104.

As exemplarily shown, first, second, third and fourth directional sensing devices 311-314 are directed to a first predetermined spatial area, i.e. such that they are sensitive to electrical discharges originating from first electrical component 102.

Reference will now be made to Fig. 8, which illustrates a flowchart of a method 600 for determining the presence of an electrical discharge X in at least one predetermined spatial area of an electrical apparatus according to embodiments of the present disclosure. Method 600 is an extension embodiments of the method 200 described above. Method 600 starts at block 601 and ends at block 611. In the providing step 602, at least one sensing device 311-314 is provided wherein the at least one sensing device 311-314 is directional, and the at least one sensing device 311-314 is directed to be sensitive to at least one subset of the at least one predetermined spatial areas. Further, the predetermined mapping 130 further includes data corresponding to a direction in which each of the at least one sensing devices 311-314 is directed. Note that elements of the flowchart of Fig. 8 which include dashed lines are optional elements.

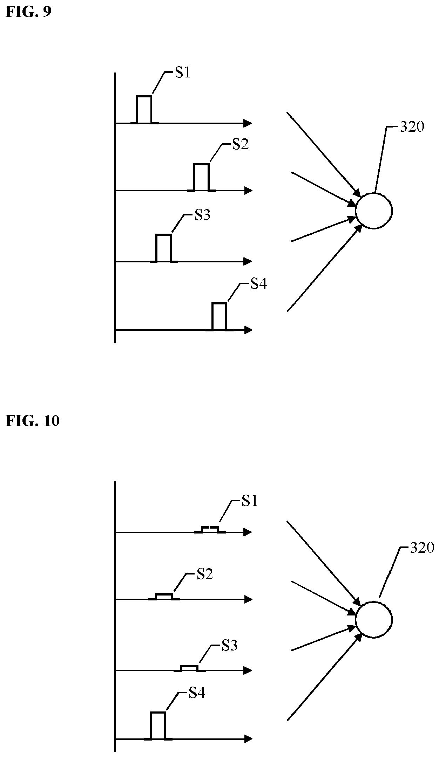

Further description of the method 600 in the following will make further reference to Fig. 9, which shows a signal diagram of the signals detected by detection system 300 using method 600.

In the providing step 602, the positions and orientations, particularly the directional sensitivities, of each of first, second, third and fourth directional sensing devices 311-314 are set. Method 600 may be performed using a single signal sensed by a single sensing device, as the method 600 is further enhanced by the use of a directional sensing device. In this case, a targeted monitoring of a single electrical component may be carried out. However, method 600 according to embodiments of the present disclosure is particularly powerful when multiple signals are sensed by multiple sensing devices.

According to an embodiment, which may be combined with other embodiments herein, in the providing step 602, the at least one sensing device 311-314 includes a first directional sensing device 311 directed to a first subset of the at least one predetermined spatial areas and at least one second directional sensing device 312-314 directed to at least one second subset of the at least one predetermined spatial areas. Further, the sensing step 604 includes sensing at least two signals S1-S4 using the first directional sensing device 311 and the at least one second directional sensing device 312-314, and the processing step 607 includes processing the at least two signals S1-S4 based on the predetermined mapping 130 to determine the presence or the electrical discharge X in the at least one predetermined spatial area.

In the present example of Fig. 7, a first predetermined spatial area is defined at the location of first electrical component 102, a second predetermined spatial area is defined at the location of second electrical component 103, and a third predetermined spatial area is defined at the location of third electrical component 104. The first, second, third and fourth directional sensing devices 311-314 are directed to be sensitive to at least one of the predetermined spatial areas. In the present example, the first, third and fourth directional sensing devices 311, 313, 314 are directed to the first predetermined spatial area corresponding to the position of the first electrical component 102. Second directional sensing device 312 is directed not only to the first predetermined spatial area, but also to the second and third predetermined spatial areas corresponding to the positions of the second and third electrical components 103, 104, respectively. In other words, the first, third and fourth directional sensing devices 311, 313, 314 are directed to a first subset of predetermined spatial areas, while the second directional sensing device 312 is directed to a second subset of predetermined spatial areas.

According to an embodiment, which may be combined with other embodiments described herein, the first subset and the at least one second subset are overlapping. In other words, the first subset and the at least one second subset each include at least one predetermined spatial area which is common to the first subset and to the at least one second subset. For example, for monitoring the first electrical component 102, the first and second subsets of predetermined spatial areas are overlapping at the first predetermined spatial area, i.e. the position of the first electrical component 102.

In the sensing step 605, at least one signal S1-S4 is detected by at least one directional sensing device 310. In the present example, first signal S1 is detected by first directional sensing device 311, second signal S2 is detected by second directional sensing device 312, third signal S3 is detected by third directional sensing device 313 and fourth signal S4 is detected by fourth directional sensing device 314. Due to the different distances between each one of first, second, third and fourth directional sensing devices 311-314 and first electrical component 102, i.e. the origin of electrical discharge X, the first, second, third and fourth signals S1-S4 are sensed by each respective directional sensing device at different times when the signals S1-S4 are time-synchronized. However, in the present disclosure, whether or not the signals S1-S4 are time-synchronized or not has no effect, as there is no time of flight calculation or time-sensitive factors by which method 600 allows for determining the presence or absence of an electrical discharge in a particular predetermined spatial area. Therefore, a more robust, less expensive and less complex detection system may be realized in comparison to a system requiring that the signals be time-synchronized.

In the processing step 607, the first, second, third and fourth signals S1-S4 are processed based on a predetermined mapping 130. The processing may be a comparison, a combination or a correlation performed by a signal processing device 320, which accepts each one of first, second, third and fourth signals S1-S4 as inputs. By comparing, combining or correlating the first, second, third and fourth signals S1-S4 based on the predetermined mapping 130, the detection system 300 is able to determine the presence or absence of an electrical discharge X in the at least one predetermined spatial area. Further, it can be determined from which one of first, second or third electrical components 102-104 the electrical discharge X originated, if at all.

In the present example, all of the first, second, third and fourth directional sensing devices 311-314 are directed to be sensitive to one predetermined spatial area. However, the present disclosure is not limited thereto, and combinations of directional sensitivity with respect to multiple predetermined spatial areas may be realized. For example, the first, second and third directional sensing devices 311-313 may be directed in the same was as shown in Fig. 7, i.e. such that each of the first, second and third directional sensing devices 311-313 is sensitive to the first predetermined spatial area. Fourth directional sensing device 314 may be directed such that it is not sensitive to the first predetermined spatial area, i.e. may be directed at the second predetermined spatial area instead. Fourth directional sensing device 314 may therefore be used as a "veto" condition, where if fourth directional sensing device 314 detects a strong signal corresponding to an electrical discharge X in the predetermined spatial area to which fourth directional sensing device 314 is sensitive, it leads that the electrical discharge X cannot be present in the first predetermined spatial area.

In this example of a sensing device being used as a "veto" condition, for monitoring of first electrical component 102, the predetermined mapping 130 may indicate that if a signal is detected by first directional sensing device 311, second directional sensing device 312 and third directional sensing device 313, but no signal or a suppressed signal is detected by fourth directional sensing device 314 which is directed to the second predetermined spatial area, this combination indicates that the electrical discharge X is present in the first predetermined spatial area, i.e. has originated from first electrical component 102. Predetermined mapping 130 further indicates combinations of signals which may indicate an electrical discharge originating from second electrical component 103, i.e. signals detected by second and fourth directional sensing devices 312, 314 but not by first and third directional sensing devices 311, 313, or an electrical discharge originating from third electrical component 104, i.e. a signal detected by second directional sensing device 312 but not by first, third and fourth directional sensing devices 311, 313, 314.

According to an embodiment, which may be combined with other embodiments described herein, the predetermined mapping 130 may include data corresponding to a direction in which each of the at least one directional sensing device 311-314 is directed and/or to which of the at least one electrical component 102-104 the at least one directional sensing device 311-314 is directed. Predetermined mapping 130 may further include data relating to a beamforming capability of the at least one sensing device, e.g. for sensing devices comprising a cluster of sensors, in which the directional sensitivity of the at least one sensing device may be "selected" or "configured" based on a number of parameters to achieve a specific directional sensitivity. In the present example, the predetermined mapping 130 may include information indicating that first directional sensing device 311 is directed to first electrical component 102, that second directional sensing device 312 is directed to first, second and third electrical components 102-104, that third directional sensing device 313 is directed to first electrical component 102, and that fourth directional sensing device 314 is directed to first electrical component 102. The predetermined mapping 130 may include the directional information in the form of a matrix.

According to an embodiment, the predetermined mapping 130 includes data corresponding to at least one reference signal, and the processing 607 includes comparing or correlating the at least one signal S1-S4 to the at least one reference signal.

Method 600 may further include a combining step, wherein each one of first, second, third and fourth signals S1-S4 are combined to generate a combined signal S. The combining may be performed by a signal processing device 320, which accepts each one of first, second, third and fourth signals S1-S4 as inputs and generates combined signal S as an output. The combination of first, second, third and fourth signals S1-S4 may be a sum or a product.

Combining first, second, third and fourth signals S1-S4 into a single combined signal S may allow for a less expensive detection system 300. For example, analog signals of the first, second, third and fourth signals S1-S4 may be combined into a single analog combined signal S prior to being digitized by an analog-digital converter (ADC), reducing the number of ADCs required to process each of the four signals in signal processing device 320.

Finally, in the processing step 607, it can be determined from combined signal S whether the electrical discharge X originated from first electrical component 102 by comparing the signature of combined signal S with a reference signal included in the predetermined mapping 130. The resulting combined signal S may have a particular signature which, when compared to a known reference signal, verifies the presence or absence of an electrical discharge X in the first predetermined spatial area. i.e. whether or not electrical discharge X originated from first electrical component 102. Different reference signals may be included in predetermined mapping 130 corresponding to the respective expected signals for electrical discharges originating from each one of first, second and third electrical components 102-104.

Accordingly, detection system 300 is also resistant to signals from internal or external disturbances. For example, a disturbance D may occur as shown in Fig. 7 such that at least fourth directional sensing device 114 may detect the disturbance D, potentially leading to an erroneous result. However, due to the comparing of the signals detected by the directional sensing devices 311-314 to a predetermined mapping 130, detection system 300 is resistant to an erroneous result being detected due to disturbance D.

The sensing of disturbance D by detection system 300 is exemplarily shown in Fig. 10. The origin of disturbance D is approximately equidistant from each one of first, second, third and fourth directional sensing devices 311-314, however the disturbance D originates from a location to which only fourth directional sensing device 314 is sensitive. As a result, first, second and third directional sensing devices 311-313 detect no signals or suppressed signals S1-S3, while fourth directional sensing device 314 detects a signal S4. However, when monitoring first electrical component 102 similarly to Fig 9, the predetermined mapping 130 indicates that, for the electrical disturbance D to originate from first electrical component 102, signals must be detected by first, second third and fourth directional sensing devices 311-314. Thus, it can be verified that disturbance D did not originate from first electrical component 102.

Similarly, it can be further verified that disturbance D did not originate from one of second electrical component 103 and third electrical component 104, either. The predetermined mapping 130 indicates that, for the electrical disturbance D to originate from second electrical component 103, a signal must be detected by the second directional sensing device 312, but no signal was detected by second directional sensing device 312. In much the same way, the predetermined mapping 130 further indicates that, for the electrical disturbance D to originate from third electrical component 104, a signal must be detected by second directional sensing device 312, but not from the first, third and fourth directional sensing devices 311, 313, 314.

In the present example, each one of first, second, third and fourth directional sensing devices 311-314 are separate devices mounted in fixed locations within compartment 101. Further, each one of first, second, third and fourth directional sensing devices 311-314 may acquire signals S1-S4 simultaneously. However, the present disclosure is not limited thereto, and the method 600 may also allow for sequential acquisition of signals S1-S4. Further to this, method 600 may also allow for adaptive directional sensing devices to be used to evaluate multiple predetermined spatial areas by re-orienting the direction in which the at least one sensing device is sensitive.

According to an embodiment, which may be combined with other embodiments described herein, in the providing step 602, the at least one sensing device 311-314 is configured to have an adaptive directional sensitivity. The sensing step 604 includes directing 605 the at least one sensing device 311-314 to be sensitive to a first subset of the at least one predetermined spatial areas, sensing 606 a first signal S1, directing 605 the at least one sensing device 311-314 to be sensitive to a second subset of the at least one predetermined spatial areas, wherein the first subset and the at least one second subset are overlapping, and sensing at least one second signal S2-S4. The processing step 607 includes processing the first signal S1 and the at least one second signal S2-S4 based on the predetermined mapping 130 to determine the presence of the electrical discharge X in the at least one predetermined spatial areas.

Optionally, the directing 605 and the sensing 606 may be repeated until all subsets of the at least one predetermined spatial areas are iterated, as exemplarily shown as the optional dashed line in the flowchart of Fig. 8. Further optionally, the method 600 may include additional providing step 603 whereby a further predetermined mapping 130 including data and/or information relevant to the further predetermined spatial areas is provided.

By providing adaptive directional sensing devices and re-orienting the directional sensitivity for each subset of predetermined spatial areas, an electrical apparatus having a large number of electrical components may be adequately monitored with only a comparatively small number of sensing devices. Further, such a method allows for reconfiguration of the monitoring scheme without having to physically move or re-orient any of the sensing devices, as the orientation and subsets of predetermined spatial areas being monitored can be adaptively altered. According to an embodiment, which may be combined with other embodiments described herein, the first directional sensing device 311 and the at least one second directional sensing device 312-314 is a single directional sensing device which is movable, and wherein the providing 602 and the sensing 606 includes providing 602 the single directional sensing device directed to the first subset of the at least one predetermined spatial areas, sensing 606 a first one of the at least two signals S1, providing 602 the single directional sensing device directed to the at least one second subset of the at least one predetermined spatial areas, and sensing 606 a further one of the at least two signals S2-S4. By providing only a single directional sensing device, the detection system 300 may be more cost-effective to implement and maintain.

According to an embodiment, which may be combined with other embodiments described herein, the at least one sensing device is a single sensing device mounted to a movable robotic manipulator. The movable robotic manipulator may be, for example, a movable robotic arm. The movable robotic manipulator may be capable of positioning the single directional sensing device at a predetermined position within the electrical apparatus, particularly within compartment 101, and may be capable of orienting the single directional sensing device in predetermined direction so as to be sensitive to a predetermined subset of electrical components. The predetermined positions and/or predetermined directions may be included in predetermined mapping 130. By sequentially acquiring signals S 1-S4 from the predetermined positions and directions, the signals S1-S4 may be first acquired and then processed in order to determine the location of the origin of an electrical discharge.

The movable robotic manipulator may be automatically controlled, for example, by a controller. The controller may be programmed to move the signal directional sensor into each of the predetermined positions and directions and acquire a signal at each of the predetermined positions and directions. The movable robotic manipulator may position and orient the single directional sensing device at a first position, acquire a signal, position and orient the signal directional sensing device at a second position, acquire a signal, and so forth. The automatic control of the movable robotic manipulator may be carried out on a predetermined inspection timetable. Alternatively, the movable robotic manipulator may be remotely controlled by an operator, allowing for the inspection of an electrical apparatus without the operator physically being present at the electrical apparatus.

According to an embodiment, which may be combined with other embodiments described herein, the single sensing device is mounted to a movable handheld device. In some situations, inspection by an on-site operator may be required. For example, if multiple electrical discharges are occurring simultaneously, an automatic, predefined method may not be able to sufficiently determine the origin of each electrical discharge. Or, the electrical apparatus may not be fitted with a detection system for cost or practicality reasons. The detection system 300 may be in the form of a handheld device, which may be include a single directional sensing device which may be positioned and oriented by an operator. The operator may position and orient the single directional sensing device at a first position, acquire a signal, position and orient the signal directional sensing device at a second position, acquire a signal, and so forth. The handheld device may have predetermined mapping 130 loaded into a storage means. The handheld device may further include a display to present information to the operator. For example, the display may show the operator, i.e. from the predetermined mapping 130, in which position and orientation the single directional sensing device should be, so that the appropriate signals may be acquired.

The methods according to the embodiments as described herein may be further improved by identifying the type of electrical discharge. According to an embodiment, which may be combined with other embodiments described herein, method 200, 400, 600 may further include identifying a type of electrical discharge X from the at least one signal S1-S4, wherein the processing 207, 407, 607 further includes determining the presence of the electrical discharge X in the at least one predetermined spatial area based on the type of electrical discharge X.

As mentioned previously, the type of electrical discharge may indicate a level of criticality of the electrical discharge depending on the electrical component from which the electrical discharge originates. Further, the type of electrical discharge may provide further information for locating the origin of the electrical discharge. For example, some types of electrical components are susceptible to partial discharges, while other types of electrical components are susceptible to corona discharges.

As an example, a directional sensing device used in detection system 300 of the second aspect may be directed so as to be sensitive to electrical discharges originating from two electrical components of different types. The first electrical component may only be susceptible to internal partial discharges, while the second electrical component may only be susceptible to corona discharges. If the directional sensing device detects a signal which can be identified as a partial discharge, it can be determined that the electrical discharge originated from the first electrical component.

For example, at least one of the sensing devices 110, 310 of detection system 100, 300 may be sensitive to both electromagnetic waves and acoustic waves such that a combined signal is generated, including a signal component corresponding to the electromagnetic wave and a signal component corresponding to the acoustic wave. A signal processing device may be configured to process the combined signal to determine the properties and/or characteristics of the electrical discharge to identify the type. For example, a combined signal including an electromagnetic component but not an acoustic component may indicate that the electrical discharge is a special type of partial discharge. However, the present disclosure is not limited thereto, and any technique known in the state of the art may be implemented to identify the type of electrical discharge.

Further, the sensing device used for the identification of the type of electrical discharge may be one of the at least one sensing devices of the detection system 100, 300, or may be a further sensing device dedicated only to identification of the type of electrical discharge. For example, in some embodiments described above, the at least one sensing devices are directional in order to determine the presence of the electrical discharge in at least one predetermined spatial area. A further sensing device may be provided only for identification of the type of electrical discharge, wherein the further sensing device is omnidirectional. Alternatively, the types of energy to which the further sensing device is sensitive may be different to the at least one sensing devices for locating the origin of the electrical discharge. For example, the at least one sensing devices for locating the origin of the electrical discharge may include antennae which are sensitive only to an electromagnetic wave, while the further sensing device for identifying the type of electrical discharge may be a microphone which is sensitive to both an electromagnetic wave and an acoustic wave.

According to a further aspect of the present disclosure, a detection system 100, 300 for detecting an electrical discharge X in an electrical apparatus is provided. The detection system 100, 300 includes at least one sensing device 110, 111-114, 310, 311-314 configured for sensing an electrical discharge X, and a signal processing device 120, 320 configured for performing the method 200, 400, 600 according to embodiments of the present disclosure.

Detection system 100, 300 includes at least one sensing device 110, 111-114, 310, 311-314. The at least one sensing device is capable of detecting an electrical discharge, generating a signal S1-S4. The at least one sensing device may include any sensing devices known in the art which are configured for sensing electromagnetic waves, infrared waves, acoustic waves or light waves. Particularly, the at least one sensing device may be configured for sensing electromagnetic waves, acoustic waves, or both electromagnetic and acoustic waves. The at least one sensing device may be configured to be sensitive to a signal only in a specific direction. That is, the at least one sensing device may include directional sensing devices. In the present disclosure, any directional sensing device known in the state of the art may be included.

Detection system 100, 300 includes a signal processing device 120, 320. Signal processing device 120, 320 is configured for processing signals S1-S4 to determine the presence of the electrical discharge X in the at least one predetermined spatial area. Signal processing device 120, 320 includes at least one input channel through which at least one signal S1-S4 is received from the at least one sensing device 110, 310. Signal processing device 120, 320 may include any combination of analog and/or digital devices configured for processing electrical signals. For example, signal processing device 120, 320 may include a microprocessor and at least one analog-to-digital converter (ADC), particularly a digital signal processor (DSP).

Signal processing device 120, 320 may include at least one signal conditioner for conditioning signals S1-S4. For example, the at least one signal conditioner may be an analog amplifier, a filter, an analog-to-digital converter (ADC), or a combination of such devices, for example, an analog front-end (AFE) controller. However, the present disclosure is not limited thereto, and the at least one signal conditioner may be any analog or digital device configured for conditioning signals S1-S4.

For the detection system 100 according to some embodiments of the present disclosure, signal processing device 120 may further include at least one delay unit configured for applying a time delay T1-T4 to the at least one signal S1-S4. The at least one delay unit may be either an analog delay for operating on an analog signal, or a digital delay for operating on a digital signal, i.e. a signal S1-S4 which has been digitized by an ADC.

Detection system 100, 300 may further include a data storage means for storing predetermined mapping 130. For example, detection system 100, 300 may include any one of magnetic storage, optical storage or flash memory storage from which predetermined mapping 130 may be read. The data storage means may be read-only, or may be read-write so that predetermined mapping 130 may be updated with new or additional information. Data storage means may be included in signal processing device 120, 320, or may be a separate device which communicates with signal processing device by way of at least one data interface.

Detection system 100, 300 may further include a calibration means. The calibration means may be, for example, an emitter which is configured for emitting a wave, particularly an acoustic and/or electromagnetic wave, of a known frequency and amplitude. The emitter may be configured for being provided in the electrical apparatus, particularly in the detection system 100, 300, at a known calibration position. Predetermined mapping 130 may include data corresponding to the one or more calibration positions, in which the emitter may be positioned during calibration. By emitting a wave having a known frequency and amplitude, the signals detected by the at least one sensing device of the detection system 100, 300 may be calibrated based on a calibration mapping. The frequency and/or amplitude of the wave emitted by the emitter may be adjustable so that the detection system 100, 300 may be calibrated based on one or more frequency-dependent or amplitude-dependent responses. For example, the detection system 100, 300 may be calibrated so that the specific topology and properties of the housing in which the electrical apparatus is housed is compensated.

Although various exemplary embodiments of the invention have been disclosed, it will be apparent to those skilled in the art that various changes and modifications can be made which will achieve some of the advantages of the invention without departing from the scope of the invention. It will be obvious to those reasonably skilled in the art that other components performing the same functions may be suitably substituted. It should be mentioned that features explained with reference to a specific figure may be combined with features of other figures, even in those cases in which this has not explicitly been mentioned.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description. As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims.

### Reference numbers

- 10: Electrical switchgear
- 20: Busbar compartment
- 21: Busbars
- 24: Busbar support
- 25, 35: Bushings or contact fingers
- 30: Circuit breaker compartment
- 31: Circuit breakers
- 32: Drawers
- 40: Cable terminal compartment
- 41: Current transformers
- 42: Voltage transformers
- 43: Earthing switches
- 44, 45, 46: Cable terminations
- 50: Control compartment
- 51: Control components
- 100, 300: Detection system according to embodiments
- 101: Compartment
- 102-104: First, second and third electrical component
- 110: Sensing devices
- 111-114: First, second, third and fourth sensing device
- 120, 320: Signal processing device
- 130: Predetermined mapping
- 200, 400, 600: Method according to embodiments
- 201, 401, 601: Start of method
- 202, 402, 602: Providing at least one sensing device
- 203, 403, 603: Providing a predetermined mapping
- 204, 404, 604: Sensing step
- 207, 407, 607: Processing step
- 211, 411, 611: End of method
- 310: Directional sensing devices
- 311-314: First, second, third and fourth directional sensing device
- 408: Delaying step
- 409: Combining step
- 410: Determining step
- 605: Directing step
- 606: Sensing step
- D: Electrical disturbance
- S1-S4: First, second, third and fourth signal
- S1_{d}-S4_{d}: First, second, third and fourth delayed signal
- S: Combined signal
- T1-T4: First, second, third and fourth time delay
- X: Electrical discharge

## Claims

1. A method (200, 400, 600) for determining the presence of an electrical discharge (X) in at least one predetermined spatial area in an electrical apparatus, the method comprising:
providing (202, 402, 602) a first directional sensing device (111, 311) directed to a first subset of the at least one predetermined spatial areas and at least one second directional sensing device (112-114, 312-314) directed to at least one second subset of the at least one predetermined spatial areas;
providing (203, 403, 603) a predetermined mapping (130) comprising data corresponding to a position of the first and at least one second directional sensing devices (111-114, 311-314), a direction in which each of the first and at least one second directional sensing devices (111-114, 311-314) are directed, and a position of the at least one predetermined spatial area;
sensing (204, 404, 604) at least two signals (S1-S4) using the first and at least one second directional sensing devices (111-114, 311-314); and
processing (207, 407, 607) the at least two signals (S1-S4) based on the predetermined mapping (130) to determine the presence of the electrical discharge (X) in the at least one predetermined spatial area.

2. The method (200, 400, 600) according to claim 1, wherein the sensing (204, 404, 604) and the processing (207, 407, 607) are performed sequentially for each one of the at least one predetermined spatial areas, or the sensing (204, 404, 604) and processing (207, 407, 607) are performed simultaneously for each one of the at least one predetermined spatial areas.

3. The method (200, 400, 600) according to any one of claims 1 to 2, wherein
the electrical apparatus comprises at least one electrical component;
the at least one spatial area corresponds to the location of the at least one electrical component; and
the predetermined mapping (130) further comprises data corresponding to properties of the at least one electrical component.

4. The method (400) according to any one of claims 1 to 3, wherein the processing (407) comprises:
delaying (408) the at least two signals (S1-S4) with a respective time delay (T1-T4) to generate at least two delayed signals (S1_{d}-S4_{d}), wherein the time delay (T1-T4) is based on the predetermined mapping (130);
combining (409) the at least two delayed signals (S1_{d}-S4_{d}) to generate at least one combined signal (S); and
determining (410) the presence of the electrical discharge (X) in the at least one spatial area from the at least one combined signal (S).

5. The method (400) according to claim 4, wherein the predetermined mapping (130) further comprises data corresponding to relative spatial distances and/or expected times of flight between each of the at least one predetermined spatial area and each of the first and at least one second directional sensing device (111-114), and the time delay (T1-T4) is based on the relative spatial distances and/or expected times of flight.

6. The method (400) according to any one of claims 4 to 5 for determining the presence of an electrical discharge (X) in at least two predetermined spatial areas in the electrical apparatus, the method (400) further comprising:
performing the delaying (408), the combining (409) and the determining (410) steps wherein the respective time delay (T1-T4) is based on a distance between the respective directional sensing device (311-314) and a first one of the two or more predetermined spatial areas; and
performing the delaying (408), combining (409) and determining (410) steps wherein the respective time delay (T1-T4) is based on a distance between the respective directional sensing device (111-114) and a further one of the two or more predetermined spatial areas.

7. The method (200, 600) according to any one of claims 1 to 6, wherein the first subset and the at least one second subset are overlapping.

8. The method (200, 400, 600) according to any one of claims 1 to 7, further comprising:
identifying a type of the electrical discharge (X) from the at least one signal (S1-S4),
wherein the processing (207, 407, 607) further comprises determining the presence of the electrical discharge (X) in the at least one predetermined spatial area based on the type of the electrical discharge (X).

9. The method (200, 400, 600) according to any one of claims 1 to 8, wherein the predetermined mapping (130) includes data corresponding to at least one reference signal, and the processing (207, 407, 607) further includes comparing or correlating the at least one signal (S1-S4) to the at least one reference signal.

10. A detection system (100, 300) for detecting an electrical discharge (X) in an electrical apparatus, the system comprising:
a first directional sensing device (111, 311) and at least one second directional sensing device (112-114312-314) configured for sensing an electrical discharge (X); and
a signal processing device (120, 320) configured for performing the method (200, 400, 600) according to any one of claims 1 to 9.

11. The detection system (100, 300) according to claim 10, wherein the first and at least one second directional sensing devices (111-114, 311-314) are configured for sensing at least one of an electromagnetic wave and an acoustic wave emitted by the electrical discharge (X).

12. A method (600) for determining the presence of an electrical discharge (X) in at least one predetermined spatial area in an electrical apparatus, the method comprising:
providing (602) a first directional sensing device (311) configured to have an adaptive directional sensitivity;
providing (603) a predetermined mapping (130) comprising data corresponding to a position of the first directional sensing device (311), and a position of the at least one predetermined spatial area;
directing (605) the first directional sensing device (311) to be sensitive to a first subset of the at least one predetermined spatial areas;
sensing (606) a first signal (S1);
directing (605) the first directional sensing device (311) to be sensitive to at least one second subset of the at least one predetermined spatial areas;
sensing (606) at least one second signal (S2-S4); and
processing (607) the first signal (S1) and the at least one second signal (S2-S4) based on the predetermined mapping (130) to determine the presence of the electrical discharge (X) in the at least one predetermined spatial area.

13. The method (600) according to claim 12, wherein the first subset and the at least one second subset are overlapping.

14. The method (600) according to any one of claims 12 to 13, wherein the first directional sensing device is mounted to a movable robotic manipulator or a movable handheld device.

15. A detection system for detecting an electrical discharge (X) in an electrical apparatus, the system comprising:
a first directional sensing device (311); and
a signal processing device (120, 320) configured for performing the method (600) according to any one of claims 12 to 14.

16. Use of the detection system (100, 300) according to any one of claims 10 to 11 for performing the method (200, 400, 600) according to any one of claims 1 to 9 to determine the presence of an electrical discharge (X) in at least one predetermined spatial area in an electrical apparatus, particularly wherein the electrical apparatus is a medium-voltage or high-voltage electrical switchgear.

17. Use of the detection system (100, 300) according to claim 15 for performing the method (600) according to any one of claims 12 to 14 to determine the presence of an electrical discharge (X) in at least one predetermined spatial area in an electrical apparatus, particularly wherein the electrical apparatus is a medium-voltage or high-voltage electrical switchgear.

## Patentansprüche

1. Verfahren (200, 400, 600) zum Bestimmen des Vorhandenseins einer elektrischen Entladung (X) in mindestens einem vorbestimmten räumlichen Bereich in einer elektrischen Vorrichtung, wobei das Verfahren Folgendes umfasst:
Bereitstellen (202, 402, 602) einer ersten gerichteten Erfassungsvorrichtung (111, 311), die auf eine erste Teilmenge der mindestens einen vorgegebenen räumlichen Bereiche gerichtet ist, und mindestens einer zweiten gerichteten Erfassungsvorrichtung (112-114, 312-314), die auf mindestens eine zweite Teilmenge der mindestens einen vorgegebenen räumlichen Bereiche gerichtet ist;
Bereitstellen (203, 403, 603) eines vorbestimmten Mappings (130), das Daten umfasst, die einer Position der ersten und mindestens einer zweiten gerichteten Erfassungsvorrichtung (111-114, 311-314), einer Richtung, in die jede der ersten und mindestens einer zweiten gerichteten Erfassungsvorrichtung (111-114, 311-314) gerichtet ist, und einer Position des mindestens einen vorbestimmten räumlichen Bereichs entsprechen;
Erfassen (204, 404, 604) mindestens zweier Signale (S1-S4) unter Verwendung der ersten und mindestens einer zweiten gerichteten Erfassungsvorrichtung (111-114, 311-314); und
Verarbeiten (207, 407, 607) der mindestens zwei Signale (S1-S4) basierend auf dem vorbestimmten Mapping (130), um das Vorhandensein der elektrischen Entladung (X) in dem mindestens einen vorbestimmten räumlichen Bereich zu bestimmen.

2. Verfahren (200, 400, 600) nach Anspruch 1, wobei die Erfassung (204, 404, 604) und die Verarbeitung (207, 407, 607) nacheinander für jeden der mindestens einen vorbestimmten räumlichen Bereiche durchgeführt werden oder die Erfassung (204, 404, 604) und die Verarbeitung (207, 407, 607) gleichzeitig für jeden der mindestens einen vorbestimmten räumlichen Bereiche durchgeführt werden.

3. Verfahren (200, 400, 600) nach einem der Ansprüche 1 bis 2, wobei
die elektrische Vorrichtung mindestens eine elektrische Komponente umfasst;
der mindestens eine räumliche Bereich der Position der mindestens einen elektrischen Komponente entspricht; und
das vorbestimmte Mapping (130) ferner Daten umfasst, die den Eigenschaften der mindestens einen elektrischen Komponente entsprechen.

4. Verfahren (400) nach einem der Ansprüche 1 bis 3, wobei die Verarbeitung (407) Folgendes umfasst:
Verzögern (408) der mindestens zwei Signale (S1-S4) mit einer jeweiligen Zeitverzögerung (T1-T4), um mindestens zwei verzögerte Signale (S1_{d}-S4_{d}) zu erzeugen, wobei die Zeitverzögerung (T1-T4) auf dem vorbestimmten Mapping (130) basiert;
Kombinieren (409) der mindestens zwei verzögerten Signale (S1_{d}-S4_{d}) zum Erzeugen mindestens eines kombinierten Signals (S); und
Bestimmen (410) des Vorhandenseins der elektrischen Entladung (X) in dem mindestens einen räumlichen Bereich aus dem mindestens einen kombinierten Signal (S).

5. Verfahren (400) nach Anspruch 4, wobei das vorbestimmte Mapping (130) ferner Daten umfasst, die relativen räumlichen Entfernungen und/oder erwarteten Laufzeiten zwischen jedem des mindestens einen vorbestimmten räumlichen Bereichs und jeder der ersten und mindestens einer zweiten gerichteten Erfassungsvorrichtung (111-114) entsprechen, und die Zeitverzögerung (T1-T4) auf den relativen räumlichen Entfernungen und/oder erwarteten Laufzeiten basiert.

6. Verfahren (400) nach einem der Ansprüche 4 bis 5 zum Bestimmen des Vorhandenseins einer elektrischen Entladung (X) in mindestens zwei vorgegebenen räumlichen Bereichen in der elektrischen Vorrichtung, wobei das Verfahren (400) ferner Folgendes umfasst:
Durchführen der Schritte des Verzögerns (408), des Kombinierens (409) und des Bestimmens (410), wobei die jeweilige Zeitverzögerung (T1-T4) auf einem Abstand zwischen der jeweiligen gerichteten Erfassungsvorrichtung (311-314) und einem ersten der zwei oder mehr vorgegebenen räumlichen Bereiche basiert; und
Durchführen der Schritte des Verzögerns (408), Kombinierens (409) und Bestimmens (410), wobei die jeweilige Zeitverzögerung (T1-T4) auf einem Abstand zwischen der jeweiligen gerichteten Erfassungsvorrichtung (111-114) und einem weiteren der zwei oder mehr vorgegebenen räumlichen Bereiche basiert.

7. Verfahren (200, 600) nach einem der Ansprüche 1 bis 6, wobei sich die erste Teilmenge und die mindestens eine zweite Teilmenge überlappen.

8. Verfahren (200, 400, 600) nach einem der Ansprüche 1 bis 7, das ferner Folgendes umfasst:
Identifizieren eines Typs der elektrischen Entladung (X) anhand des mindestens einen Signals (S1-S4),
wobei die Verarbeitung (207, 407, 607) ferner das Bestimmen des Vorhandenseins der elektrischen Entladung (X) in dem mindestens einen vorbestimmten räumlichen Bereich basierend auf dem Typ der elektrischen Entladung (X) umfasst.

9. Verfahren (200, 400, 600) nach einem der Ansprüche 1 bis 8, wobei die vorbestimmte Abbildung (130) Daten beinhaltet, die mindestens einem Referenzsignal entsprechen, und die Verarbeitung (207, 407, 607) ferner das Vergleichen oder Korrelieren des mindestens einen Signals (S1-S4) mit dem mindestens einen Referenzsignal beinhaltet.

10. Erkennungssystem (100, 300) zum Erkennen einer elektrischen Entladung (X) in einer elektrischen Vorrichtung, wobei das System Folgendes umfasst:
eine erste gerichtete Erfassungsvorrichtung (111, 311) und mindestens eine zweite gerichtete Erfassungsvorrichtung (112-114, 312-314), die zum Erfassen einer elektrischen Entladung (X) ausgebildet ist; und
eine Signalverarbeitungsvorrichtung (120, 320), die zum Durchführen des Verfahrens (200, 400, 600) nach einem der Ansprüche 1 bis 9 ausgebildet ist.

11. Erkennungssystem (100, 300) nach Anspruch 10, wobei die erste und mindestens eine zweite gerichtete Erfassungsvorrichtung (111-114, 311-314) ausgebildet sind, um eine elektromagnetische Welle und/oder eine akustische Welle, die von der elektrischen Entladung (X) emittiert wird, zu erkennen.

12. Verfahren (600) zum Bestimmen des Vorhandenseins einer elektrischen Entladung (X) in mindestens einem vorbestimmten räumlichen Bereich in einer elektrischen Vorrichtung, wobei das Verfahren Folgendes umfasst:
Bereitstellen (602) einer ersten gerichteten Erfassungsvorrichtung (311), die so ausgebildet ist, dass sie eine adaptive gerichtete Empfindlichkeit aufweist;
Bereitstellen (603) eines vorbestimmten Mappings (130), das Daten umfasst, die einer Position der ersten gerichteten Erfassungsvorrichtung (311) und einer Position des mindestens einen vorbestimmten räumlichen Bereichs entsprechen;
Richten (605) der ersten gerichteten Erfassungsvorrichtung (311), um für eine erste Teilmenge der mindestens einen vorbestimmten räumlichen Bereiche empfindlich zu sein;
Erfassen (606) eines ersten Signals (S1);
Richten (605) der ersten gerichteten Erfassungsvorrichtung (311), um für mindestens eine zweite Teilmenge der mindestens einen vorbestimmten räumlichen Bereiche empfindlich zu sein;
Erfassen (606) mindestens eines zweiten Signals (S2-S4); und
Verarbeiten (607) des ersten Signals (S1) und des mindestens einen zweiten Signals (S2-S4) basierend auf dem vorbestimmten Mapping (130), um das Vorhandensein der elektrischen Entladung (X) in dem mindestens einen vorbestimmten räumlichen Bereich zu bestimmen.

13. Verfahren (600) nach Anspruch 12, wobei sich die erste Teilmenge und die mindestens eine zweite Teilmenge überlappen.

14. Verfahren (600) nach einem der Ansprüche 12 bis 13, wobei die erste gerichtete Erfassungsvorrichtung an einem beweglichen Robotermanipulator oder einer beweglichen handgeführten Vorrichtung angebracht ist.

15. Erkennungssystem zum Erkennen einer elektrischen Entladung (X) in einer elektrischen Vorrichtung, wobei das System Folgendes umfasst:
eine erste gerichtete Erfassungsvorrichtung (311); und
eine Signalverarbeitungsvorrichtung (120, 320), die zum Durchführen des Verfahrens (600) nach einem der Ansprüche 12 bis 14 ausgebildet ist.

16. Verwendung des Erkennungssystems (100, 300) nach einem der Ansprüche 10 bis 11 zum Durchführen des Verfahrens (200, 400, 600) nach einem der Ansprüche 1 bis 9, um das Vorhandensein einer elektrischen Entladung (X) in mindestens einem vorbestimmten räumlichen Bereich in einer elektrischen Vorrichtung zu bestimmen, insbesondere, wobei die elektrische Vorrichtung eine elektrische Mittel- oder Hochspannungsschaltanlage ist.

17. Verwendung des Erkennungssystems (100, 300) nach Anspruch 15 zum Durchführen des Verfahrens (600) nach einem der Ansprüche 12 bis 14, um das Vorhandensein einer elektrischen Entladung (X) in mindestens einem vorbestimmten räumlichen Bereich in einer elektrischen Vorrichtung zu bestimmen, insbesondere, wobei die elektrische Vorrichtung eine elektrische Mittelspannungs- oder Hochspannungsschaltanlage ist.

## Revendications

1. Procédé (200, 400, 600) de détermination de la présence d'une décharge électrique (X) dans au moins une zone spatiale prédéterminée d'un appareil électrique, le procédé comportant les étapes consistant à :
mettre en place (202, 402, 602) un premier dispositif directionnel (111, 311) de détection orienté vers un premier sous-ensemble de la ou des zones spatiales prédéterminées et au moins un second dispositif directionnel (112-114, 312-314) de détection orienté vers au moins un second sous-ensemble de la ou des zones spatiales prédéterminées ;
mettre en place (203, 403, 603) un mappage prédéterminé (130) comportant des données correspondant à une position du premier et du ou des seconds dispositifs directionnels (111-114, 311-314) de détection, à une direction dans laquelle chacun du premier et du ou des seconds dispositifs directionnels (111-114, 311-314) de détection sont orientés, et à une position de la ou des zones spatiales prédéterminées ;
détecter (204, 404, 604) au moins deux signaux (S1-S4) à l'aide du premier et du ou des seconds dispositifs directionnels (111-114, 311-314) de détection ; et
traiter (207, 407, 607) lesdits au moins deux signaux (S1-S4) d'après le mappage prédéterminé (130) pour déterminer la présence de la décharge électrique (X) dans la ou les zones spatiales prédéterminées.

2. Procédé (200, 400, 600) selon la revendication 1, la détection (204, 404, 604) et le traitement (207, 407, 607) étant effectués successivement pour la ou chacune des zones spatiales prédéterminées, ou la détection (204, 404, 604) et le traitement (207, 407, 607) étant effectués simultanément pour la ou chacune des zones spatiales prédéterminées.

3. Procédé (200, 400, 600) selon l'une quelconque des revendications 1 à 2,
l'appareil électrique comportant au moins un composant électrique ;
la ou les zones spatiales correspondant à l'emplacement du ou des composants électriques ; et
le mappage prédéterminé (130) comportant en outre des données correspondant à des propriétés du ou des composants électriques.

4. Procédé (400) selon l'une quelconque des revendications 1 à 3, le traitement (407) comportant les étapes consistant à :
retarder (408) lesdits au moins deux signaux (S1-S4) d'un retard temporel respectif (T1-T4) pour générer au moins deux signaux retardés (S1_{d}-S4_{d}), le retard temporel (T1-T4) étant basé sur le mappage prédéterminé (130) ;
combiner (409) lesdits au moins deux signaux retardés (S1_{d}-S4_{d}) pour générer au moins un signal combiné (S) ; et
déterminer (410) la présence de la décharge électrique (X) dans la ou les zones spatiales à partir du signal ou des signaux combinés (S).

5. Procédé (400) selon la revendication 4, le mappage prédéterminé (130) comportant en outre des données correspondant à des distances spatiales relatives et/ou à des temps de vol prévus entre la ou chacune des zones spatiales prédéterminées et chacun du premier et du ou des seconds dispositifs directionnels (111-114) de détection, et le retard temporel (T1-T4) étant basé sur les distances spatiales relatives et/ou les temps de vol prévus.

6. Procédé (400) selon l'une quelconque des revendications 4 à 5 pour déterminer la présence d'une décharge électrique (X) dans au moins deux zones spatiales prédéterminées de l'appareil électrique, le procédé (400) comportant en outre :
la réalisation des étapes de retard (408), de combinaison (409) et de détermination (410), le retard temporel respectif (T1-T4) étant basé sur une distance entre le dispositif directionnel (311-314) de détection considéré et une première desdites au moins deux zones spatiales prédéterminées ; et
la réalisation des étapes de retard (408), de combinaison (409) et de détermination (410, le retard temporel respectif (T1-T4) étant basé sur une distance entre le dispositif directionnel (111-114) de détection considéré et une autre desdites au moins deux zones spatiales prédéterminées.

7. Procédé (200, 600) selon l'une quelconque des revendications 1 à 6, le premier sous-ensemble et le ou les seconds sous-ensembles se chevauchant.

8. Procédé (200, 400, 600) selon l'une quelconque des revendications 1 à 7, comportant en outre :
l'identification d'un type de la décharge électrique (X) à partir du signal ou des signaux (S1-S4),
le traitement (207, 407, 607) comportant en outre la détermination de la présence de la décharge électrique (X) dans la ou les zones spatiales prédéterminées d'après le type de la décharge électrique (X).

9. Procédé (200, 400, 600) selon l'une quelconque des revendications 1 à 8, le mappage prédéterminé (130) comprenant des données correspondant à au moins un signal de référence, et le traitement (207, 407, 607) comprenant en outre la comparaison ou la corrélation du signal ou des signaux (S1-S4) au signal ou aux signaux de référence.

10. Système (100, 300) de détection destiné à détecter une décharge électrique (X) dans un appareil électrique, le système comportant :
un premier dispositif directionnel (111, 311) de détection et au moins un second dispositif directionnel (112-114, 312-314) de détection configurés pour détecter une décharge électrique (X) ; et
un dispositif (120, 320) de traitement de signaux configuré pour réaliser le procédé (200, 400, 600) selon l'une quelconque des revendications 1 à 9.

11. Système (100, 300) de détection selon la revendication 10, le premier et le ou les seconds dispositifs directionnels (111-114, 311-314) de détection étant configurés pour détecter une onde électromagnétique et/ou une onde acoustique émises par la décharge électrique (X).

12. Procédé (600) de détermination de la présence d'une décharge électrique (X) dans au moins une zone spatiale prédéterminée d'un appareil électrique, le procédé comportant les étapes consistant à :
mettre en place (602) un premier dispositif directionnel (311) de détection configuré pour présenter une sensibilité directionnelle adaptative ;
mettre en place (603) un mappage prédéterminé (130) comportant des données correspondant à une position du premier dispositif directionnel (311) de détection, et à une position de la ou des zones spatiales prédéterminées ;
orienter (605) le premier dispositif directionnel (311) de détection pour qu'il soit sensible à un premier sous-ensemble de la ou des zones spatiales prédéterminées ;
détecter (606) un premier signal (S1) ;
orienter (605) le premier dispositif directionnel (311) de détection pour qu'il soit sensible à au moins un second sous-ensemble de la ou des zones spatiales prédéterminées ;
détecter (606) au moins un second signal (S2-S4) ; et
traiter (607) le premier signal (S1) et le ou les seconds signaux (S2-S4) d'après le mappage prédéterminé (130) pour déterminer la présence de la décharge électrique (X) dans la ou les zones spatiales prédéterminées.

13. Procédé (600) selon la revendication 12, le premier sous-ensemble et le ou les seconds sous-ensembles se chevauchant.

14. Procédé (600) selon l'une quelconque des revendications 12 à 13, le premier dispositif directionnel de détection étant monté sur un manipulateur robotisé mobile ou un dispositif portatif mobile.

15. Système de détection destiné à détecter une décharge électrique (X) dans un appareil électrique, le système comportant :
un premier dispositif directionnel (311) de détection ; et
un dispositif (120, 320) de traitement de signaux configuré pour réaliser le procédé (600) selon l'une quelconque des revendications 12 à 14.

16. Utilisation du système (100, 300) de détection selon l'une quelconque des revendications 10 à 11 pour réaliser le procédé (200, 400, 600) selon l'une quelconque des revendications 1 à 9 afin de déterminer la présence d'une décharge électrique (X) dans au moins une zone spatiale prédéterminée d'un appareil électrique, l'appareil électrique étant en particulier un appareillage de connexion électrique à moyenne tension ou haute tension.

17. Utilisation du système (100, 300) de détection selon la revendication 15 pour réaliser le procédé (600) selon l'une quelconque des revendications 12 à 14 afin de déterminer la présence d'une décharge électrique (X) dans au moins une zone spatiale prédéterminée d'un appareil électrique, l'appareil électrique étant en particulier un appareillage de connexion électrique à moyenne tension ou haute tension.
